Europäisches Patentamt

European Patent Office

Office européen des brevets

(19)

(11) **EP 1 443 658 A1**

(12) ## DEMANDE DE BREVET EUROPEEN

(43) Date de publication:
**04.08.2004 Bulletin 2004/32**

(51) Int Cl.⁷: **H03M 13/29**

(21) Numéro de dépôt: **04290220.5**

(22) Date de dépôt: **28.01.2004**

(84) Etats contractants désignés:
**AT BE BG CH CY CZ DE DK EE ES FI FR GB GR HU IE IT LI LU MC NL PT RO SE SI SK TR**
Etats d'extension désignés:
**AL LT LV MK**

(30) Priorité: **03.02.2003 FR 0301191**

(71) Demandeur: **Nortel Networks Limited St. Laurent, Quebec H4S 2A9 (CA)**

(72) Inventeur: **Taffin, Arnauld Alain Gérard 75014 Paris (FR)**

(74) Mandataire: **Loisel, Bertrand Cabinet Plasseraud 65/67 rue de la Victoire 75440 Paris Cedex 09 (FR)**

(54) **Procédé de contrôle du nombre d'itérations d'un processus de décodage itératif et dispositif pour la mise en oeuvre du procédé**

(57) On contrôle le nombre d'itérations d'un processus de décodage itératif d'une séquence de symboles codée selon un schéma de codage par concaténation de codes convolutifs dans les cas de non convergence. On calcule tout d'abord une grandeur liée à la convergence du processus de décodage itératif, puis on compare cette grandeur à un seuil de non convergence. En fonction de cette comparaison, on stoppe le processus de décodage itératif en déclarant la séquence non décodée.

FIG.2.

**Description**

La présente invention concerne les techniques de décodage itératif de données numériques codées selon des schémas de concaténation de codes correcteurs d'erreurs. Elle s'applique en particulier aux procédés de décodage itératif ("turbo décodage") de codes concaténés en parallèle.

La présente invention trouve notamment application dans les systèmes de transmission de données numériques ou de stockage d'information sous forme numérique.

Les études menées sur la concaténation de codes, initiées par Elias (voir P. Elias, "Error-free coding", IRE Trans. On Information Theory, pp. 29-37, 1954) et développées par Forney (voir G.D. Forney, "Concatened codes", Cambridge, MA: MIT res. Monograph no 37, MIT Press, 1966) ont encouragé le développement de méthodes de décodage itératif qui se sont avérées particulièrement bien adaptées aux codes concaténés formés par la concaténation, série ou parallèle, de plusieurs codes constituants. Durant la dernière décennie, une famille de codes concaténés, constituée de codes convolutifs concaténés en parallèle (PCCC - Parallel Convolutional Concatened Codes) avec entrelacement entre les codes, couramment appelés "turbo-codes", a suscité un intérêt particulier dans le monde de la recherche et dans l'industrie.

Dans une configuration classique, un turbo-codeur est constitué d'une pluralité de codeurs convolutifs, typiquement des codeurs convolutifs systématiques récursifs de type RSC ("Recursive systematic convolutional") concaténés en parallèle, qui peuvent ou non être identiques. Les données binaires d'entrée de chaque codeur constituant au-delà du premier codeur sont une version permutée des données d'entrée du premier codeur constituant, générant ainsi en sortie des séquences binaires de parité redondantes. Outre les séquences binaires de parité, les données en sortie de l'encodeur reprennent à l'identique les données binaires d'entrée lorsqu'on utilise des codeurs constituants systématiques.

Dans les notations utilisées dans toute la suite, n désigne l'index des itérations du processus de décodage itératif ($1 \leq n \leq N\_ITE\_MAX$), k désigne l'index des numéros d'ordre des bits des séquences de symboles binaires, I désigne des données en sortie d'un opérateur de permutation. Cette opération de permutation est en pratique réalisée par des modules entrelaceurs, auxquels correspondent des modules désentrelaceurs qui réalisent l'opération inverse de la permutation effectuée par les entrelaceurs.

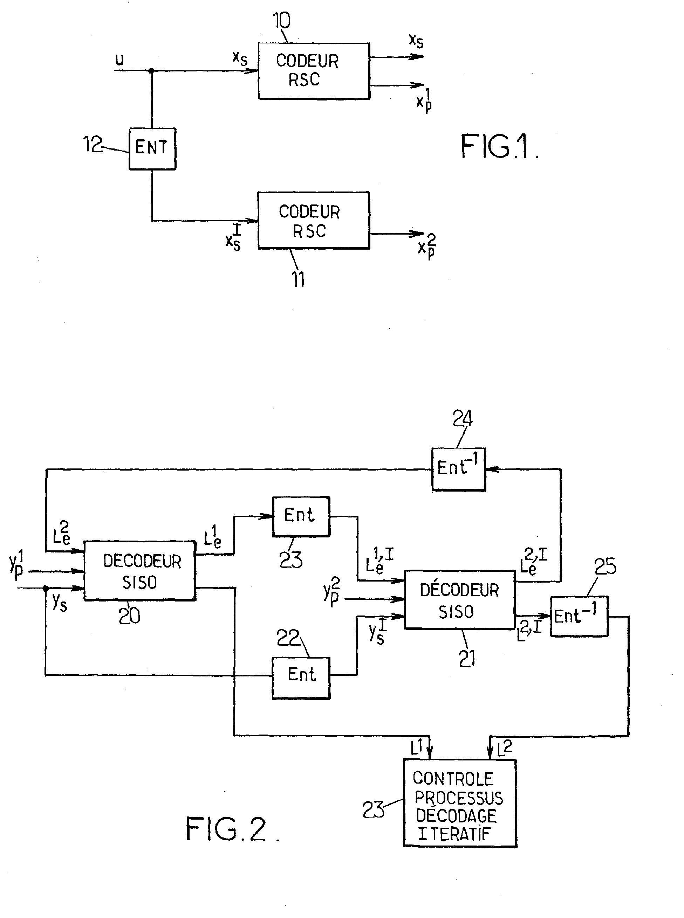

La figure 1 présente un schéma illustrant un turbo-encodeur classique comprenant deux codeurs constituants (10, 11 ) RSC fonctionnant en parallèle et un entrelaceur (12) disposé en amont de l'entrée du second codeur. On note ($\vec{u} = (u^1, u^2, ..., u^N)$) la séquence de variables aléatoires binaires représentant l'information à coder. Cette séquence $\vec{u}$ en entrée du turbo-codeur est appliquée au premier codeur (10), qui les reproduit à l'identique en sortie, constituant ainsi une séquence de bits systématiques ($\vec{x}_s = (x^1_s, x^2_s, ..., x^N_s)$) en sortie de l'encodeur. Une version permutée ($\vec{x}^I_s$) des données d'entrée de l'encodeur est appliquée en entrée du second codeur (11) par l'intermédiaire de l'entrelaceur (12). Les sorties non systématiques des codeurs (10, 11) forment le groupe ($\vec{x}^1_p, \vec{x}^2_p$) de séquences de bits de parité en sortie de l'encodeur.

L'utilisation de turbo-codes est actuellement prévue dans les réseaux cellulaires de troisième génération du fait de ses performances supérieures à celles d'autres codes concaténés. Pour les systèmes de type UMTS ("Universal Mobile Telecommunications System") l'utilisation de turbo-codes pour le codage canal de canaux de transport est décrite dans la spécification technique 3G TS 25.212, "Multiplexing and channel coding (FDD) - Release 1999", version 3.9.0 , publiée en décembre 2001 par le 3GPP.

Différentes méthodes de décodage des codes concaténés ont été développées. Le principe de décodage itératif, particulièrement bien adapté à ces codes, a notamment été décrit par S. Gallager pour le décodage des codes LDPC (Low-Density Parity-Check) (voir "Low-Density Parity-Check Codes", R. Gallager, IRE Trans. On Information Theory, Jan. 1962, et "Low-Density Parity-Check Codes", R. Gallager, M.I.T. Press, Cambridge, Mass.; 1963). Le décodeur comprenant un décodeur constituant pour chaque codeur constituant de l'encodeur, l'estimation obtenue en sortie d'un décodeur constituant est utilisée comme information d'entrée d'un autre décodeur constituant.

Le schéma de décodage itératif développé pour les turbo-codes est à l'origine de leur succès croissant. Il a par la suite été étendu à d'autres codes concaténés, comme des codes convolutifs concaténés en série (voir S. Benedetto, G. Montorsi, D. Divsalar, F. Pollara, "Serial concatenation of interleaved codes: Performance analysis, design and iterative decoding", TDA Progress report 42-126, JPL, Avril-Juin 1996).

La figure 2 présente un schéma illustrant un turbo-décodeur itératif classique adapté à l'encodeur de la figure 1.

Le décodeur reçoit en entrée une séquence de symboles binaires ($\vec{y}$) comprenant trois groupes de symboles ($\vec{y}_s, \vec{y}^1_p, \vec{y}^2_p$) correspondant respectivement aux séquences ($\vec{x}_s, \vec{x}^1_p, \vec{x}^2_p$) de symboles produites par l'encodeur. La séquence de symboles ($\vec{y}_s$) correspondant à la séquence ($\vec{x}_s$) de bits systématiques est fournie au premier décodeur (20) constituant, tandis qu'une version entrelacée ($\vec{y}^I_s$) par un entrelaceur (22) est fournie au second décodeur (21) constituant. Les séquences ($\vec{y}^1_p, \vec{y}^2_p$) correspondant aux bits de parité sont fournies aux premier et second décodeurs constituants, respectivement. Chaque décodeur (20, 21) constituant est un décodeur à entrées et sorties souples (de type SISO - "Soft Input Soft Output"), et produit une séquence d'estimations dites "souples" (séquence d'estimations de symboles décodés accompagnées d'une information de mesure de fiabilité) ainsi que des informations dérivées de ces estimations sous la forme d'un couple de séquences ($\vec{L}^1$, $\vec{Le}^1$) et ($\vec{L}^{2,I}$, $\vec{Le}^{2,I}$, respectivement. L'algorithme de décodage mis en oeuvre dans les décodeurs (20, 21) peut être de type MAP ("Maximum A Posteriori") ou dérivé (algorithmes "max-log-MAP" ou "log-MAP"), ou bien de type Viterbi à sorties souples (SOVA - "Soft Output Viterbi Algorithm"). Une version ($\vec{Le}^{1,I}$) entrelacée par un entrelaceur (23) de la séquence ($\vec{Le}^1$) produites par le premier décodeur (20) est fournie en entrée du second décodeur (21). Une version ($\vec{Le}^2$) désentrelacée par un désentrelaceur (24) de la séquence ($\vec{Le}^{2,I}$) produite par le second décodeur (21) est fournie en entrée du premier décodeur (20) constituant.

Les quantités $(L^{j\_dec})_{j\_dec=1,2}$ communément appelées LLR ("Log Likelihood Ratio"), représentent le rapport des probabilités a posteriori que l'élément $u^k$ de la séquence ($\vec{u}$) décodée prenne l'une ou l'autre des valeurs binaires possibles. Elles sont obtenues par les décodeurs (20,21) selon la relation (1) :

$$L^{j\_dec}(u^k) = \log_e \left[ \frac{Pr\,ob(u^k = 1|\vec{y})}{Pr\,ob(u^k = 0|\vec{y})} \right] \quad k = 1...N \qquad (1)$$

La quantité $L^{j\_dec}(u_k)$ représente une estimation pondérée du fait que son signe indique une estimation correspondant à la meilleure décision $\hat{u}_k$ relative au symbole émis $u_k$, tandis que son module mesure la fiabilité de cette décision.

Les séquences $(Le^{j\_dec})_{j\_dec=1,2}$ représentent une quantité d'information dite "extrinsèque", correspondant à la partie itérative transmise d'un décodeur à l'autre. Elles sont échangées entre les décodeurs (20,21), pour être utilisées à chaque itération du processus de décodage. A l'itération n, les quantités $(Le_n^{j\_dec})_{j\_dec=1,1}$ sont déterminées selon les relations (2) et (3) :

$$Le_n^1(\hat{u}_n^k) = -Le_{n-1}^2(\hat{u}_n^k) - L_c \cdot y_k + L_n^1(\hat{u}_n^k) \qquad k = 1....N \qquad (2)$$

$$Le_n^{2,I}(\hat{u}_n^k) = -Le_{n-1}^{1,I}(\hat{u}_n^k) - L_c \cdot y_k + L_n^{2,I}(\hat{u}_n^k) \qquad k = 1...N \qquad (3)$$

Dans les équations (2) et (3), le facteur ($L_c$) représente la contribution d'un canal de transmission des données encodées sur les données reçues ($y_k$).

En pratique, il est usuel de fixer un nombre maximum d'itérations N_ITE_MAX au-delà duquel on stoppe le processus itératif de décodage. La valeur de N_ITE_MAX dépendra de l'application. Elle est de l'ordre de 8 dans les applications de radiocommunication pour les systèmes de troisième génération. Un module (23) de contrôle du processus itératif de décodage actionne les décodeurs constituants (20, 21) pour produire les résultats du décodage et commande le déroulement du processus durant le nombre maximum d'itérations prévues ou selon un algorithme de contrôle du nombre d'itérations.

Une description détaillée d'algorithmes de décodage itératif est fournie dans l'article de Hagenauer et al. "Iterative Decoding of Binary Block and Convolutional Codes" (IEEE Transactions on Information Theory, vol. 42, No. 2, Mars 1996).

Plusieurs études ont été menées dans le but de réduire le nombre d'itérations du processus de turbo-décodage effectuées en situation de convergence anticipée. Des critères d'arrêt des itérations de décodage ont ainsi été définis, permettant de stopper prématurément le processus de décodage itératif lorsque l'on considère que les itérations déjà effectuées ont conduit à des estimations suffisamment satisfaisantes. On pourra sur ce sujet se reporter aux articles suivants :

- "Two Simple Stopping Criteria for Iterative Decoding", Shao et al., IEEE Transactions on Communications, Volume: 47 Issue: 8 , Août 1999 ;
- "Reducing average number of turbo decoding iterations", Shibutani et al., IEE Electronics letters, Avril 1999, vol. 35, N°9 ;
- "Increasing throuput of iterative decoders", Vogt et al., IEE Electronics letters, Juin 2001, vol. 37, N°12.

Dans le cadre d'une mise en oeuvre des schémas de décodage itératif dans le domaine des radiocommunications, et particulièrement lorsqu'on envisage leur implémentation au sein d'un terminal de radiocommunication, la complexité de tels schémas est un paramètre qu'il convient d'optimiser. L'utilisation de ressources de calcul (processeur de traitement de signal, coprocesseur, etc.) est à cet égard un facteur de consommation énergétique, dont la diminution contribue à augmenter l'autonomie d'un terminal.

Un but de la présente invention est d'optimiser les procédés de décodage itératif.

L'invention propose ainsi un procédé de contrôle du nombre d'itérations d'un processus de décodage itératif d'une séquence de symboles codée selon un schéma de codage par concaténation de codes convolutifs, dans lequel, pour une itération au-delà de la première, on calcule une grandeur liée à la convergence du processus de décodage itératif, on compare cette grandeur à un seuil de non convergence, et on stoppe le processus de décodage itératif en fonction de cette comparaison en déclarant la séquence non décodée.

L'invention repose sur l'observation, en vue d'une prise en compte précoce, des situations de non convergence d'un algorithme itératif de décodage. Les cas de non convergence se rencontrent lorsqu'une séquence à décoder a été tellement altérée par la transmission des données qu'elle ne serait pas exploitable, quand bien même on procéderait au nombre maximal d'itérations du processus de décodage.

Un autre aspect de la présente invention se rapporte à un dispositif de contrôle du nombre d'itérations d'un processus de décodage itératif, comprenant des moyens pour calculer une grandeur liée à la convergence du processus de décodage itératif, des moyens pour comparer cette grandeur à un seuil de non convergence, et des moyens pour stopper le processus de décodage itératif en fonction de cette comparaison en déclarant la séquence non décodée.

De préférence, les moyens pour calculer une grandeur liée à la convergence du processus de décodage itératif comprendront des moyens pour mesurer l'écart entre deux estimations de la séquence de symboles obtenues lors d'itérations distinctes du processus de décodage, ces moyens étant typiquement agencés pour mesurer ledit écart selon une distance de Hamming.

L'invention vise également un programme d'ordinateur, chargeable dans une mémoire associée à un processeur, et comprenant des portions de code pour la mise en oeuvre d'un procédé tel que défini ci-dessus lors de l'exécution dudit programme par le processeur, ainsi qu'un support informatique sur lequel est enregistré un tel programme.

L'invention peut être avantageusement mise en oeuvre conjointement avec des critères d'arrêt du décodage sur convergence anticipée, tels que ceux décrits dans les articles mentionnés précédemment.

D'autres particularités et avantages de la présente invention apparaîtront dans la description ci-après d'exemples de réalisation non limitatifs, en référence aux dessins annexés, dans lesquels :

- la figure 1 est un schéma d'un encodeur turbo conventionnel ;
- la figure 2 est un schéma d'un décodeur turbo conventionnel auquel l'invention peut s'appliquer ;
- la figure 3 est un organigramme illustrant le procédé selon l'invention dans un premier mode de réalisation ;
- la figure 4 est un organigramme illustrant le procédé selon l'invention dans un second mode de réalisation de l'invention ;
- la figure 5 est un schéma illustrant un dispositif selon l'invention. L'invention est décrite ci-après dans son application non limitative à un turbo décodeur.

Selon l'invention, on calcule une estimation de chaque symbole de la séquence à décoder lors d'une itération n du processus de décodage, avec $n \geq 1$. Dans un mode préféré de réalisation de l'invention, cette estimation, dite "dure", est obtenue en déterminant le signe des quantités LLR ($L_n^2$) obtenues après désentrelacement à partir de la sortie ($L_n^{2,l}$) du second décodeur constituant soumise au désentrelaceur (25).

Dans une autre étape selon l'invention, on calcule une grandeur liée à la convergence du processus de décodage itératif. De préférence, cette grandeur mesure l'écart entre deux estimations de la séquence de symboles obtenues lors d'itérations distinctes du processus de décodage. De manière avantageuse, cet écart est calculé au sens de la distance de Hamming (nombre de positions binaires qui diffèrent entre les deux séquences).

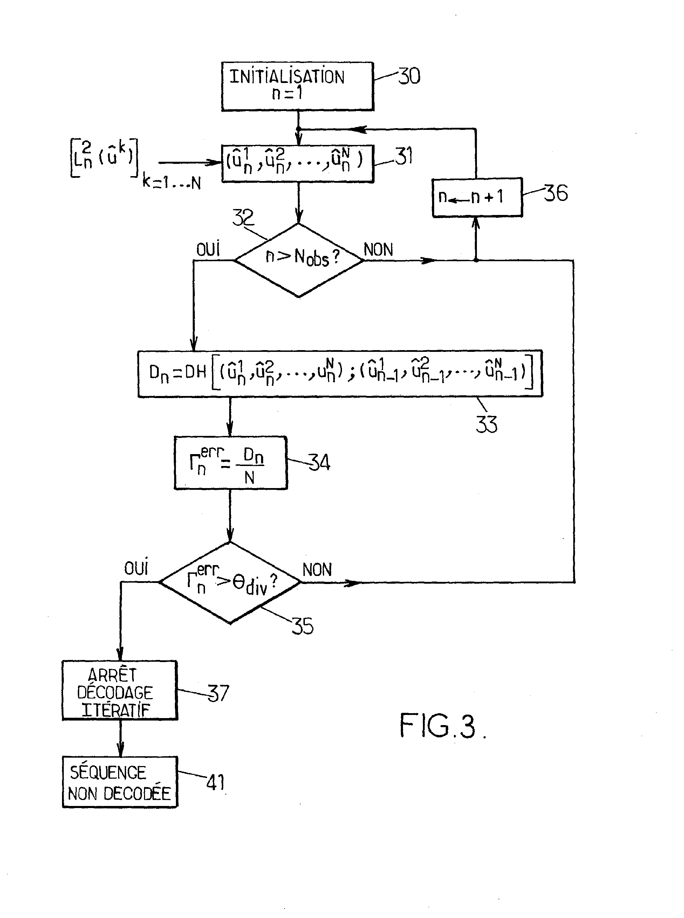

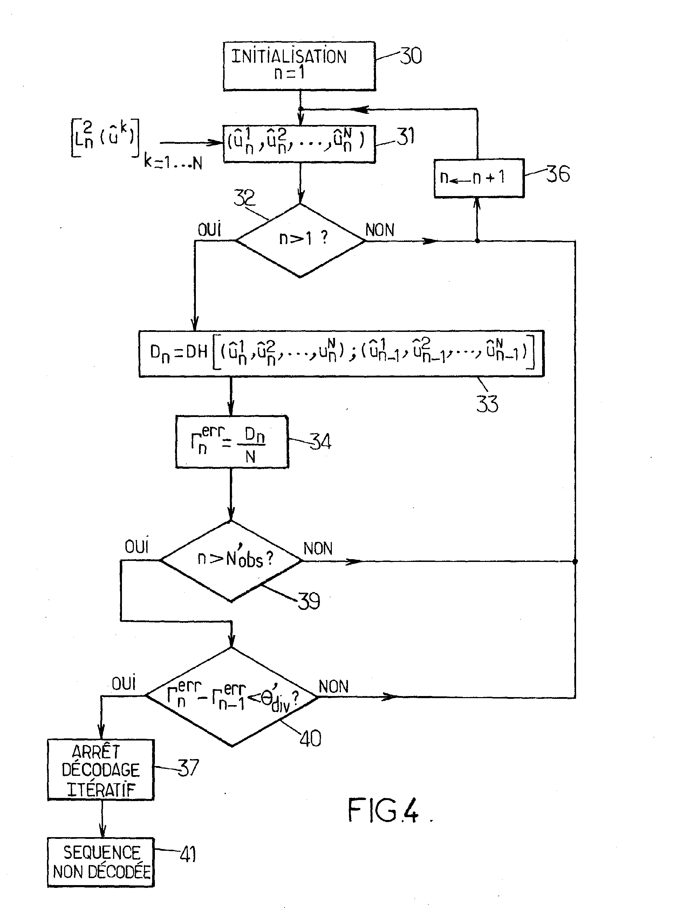

Les algorithmes présentés sur les figures 3 et 4 seront typiquement mis en oeuvre au sein du module (23) de contrôle décrit précédemment. Ce module pourra donc piloter la succession des itérations du processus de décodage eu égard au nombre maximum prévu en utilisant un critère d'arrêt sur divergence selon l'invention et éventuellement un critère d'arrêt sur convergence.

L'algorithme représenté sur la figure 3 est initialisé avec $n = 1$. Une boucle est exécutée pour les valeurs successives de l'index n. Chaque itération n dans cette boucle commence par l'obtention (31) de la séquence d'estimations ($\hat{u}_n^1$, $\hat{u}_n^2$,...$\hat{u}_n^N$) à partir des quantités $L^2(u^k)$ dont on détermine le signe. L'étape (31) est ainsi exécutée de manière coordonnée avec le processus de décodage itératif dont l'exécution fournit les quantités $L^2(u^k)$. Les séquences d'estimations ainsi obtenues sont ensuite mémorisées. Un test (32) est effectué pour distinguer le traitement opéré lors des premières itérations, qui se limite à l'obtention de la séquence et sa mémorisation à l'étape précédente. Le nombre d'itérations de la boucle pour lesquelles ce traitement limité est opéré est déterminé par le paramètre $N_{obs}$, choisi supérieur ou égal à 1. Un positionnement de $N_{obs}$ au-delà de 1 permet de n'appliquer le critère d'arrêt du décodage qu'au bout d'un nombre déterminé d'itérations de décodage, offrant ainsi un degré supplémentaire de flexibilité du procédé selon l'invention. Si l'itération en cours est au-delà du nombre prédéterminé $N_{obs}$, on obtient (33) la distance de Hamming $D_n$ entre la séquence d'estimations $(\hat{u}_n^1, \hat{u}_n^2, ..., \hat{u}_n^N)$ obtenue à l'étape précédente (31) et la séquence d'estimations $(\hat{u}_{n-1}^1, \hat{u}_{n-1}^2, .... \hat{u}_{n-1}^N)$ obtenue à l'étape (31) lors de l'itération précédente. En variante, on peut calculer l'écart entre la séquence d'estimations $(\hat{u}_n^1, \hat{u}_n^2, ..., \hat{u}_n^N)$ courante et la séquence d'estimations $(\hat{u}_{n-p}^1, \hat{u}_{n-p}^2, ..., \hat{u}_{n-p}^N)$ obtenue à l'étape (31) lors d'une quelconque itération précédente n-p. La quantité $D_n$ obtenue à l'étape (33) peut ensuite être normalisée à l'étape (34) par la taille N de la séquence décodée pour obtenir le critère $\Gamma_n^{err}$, qui sera comparé au seuil $\theta_{div}$ de divergence à l'étape suivante (35). L'opération de normalisation permet d'établir un critère indépendant du nombre N de symboles binaires dans une séquence. On peut aussi établir une moyenne des distances $D_n$ calculées à chaque itération n, et obtenir le critère $\Gamma_n^{err}$, sans sortir de l'esprit de l'invention. Si la valeur du critère $\Gamma_n^{err}$ excède la valeur du seuil $\theta_{div}$, le décodage itératif est stoppé (37) et la séquence déclarée non décodée (41).

La sortie des tests (32) et (35) lorsque la condition de test n'est pas remplie conduit à l'incrémentation (36) de l'indice n d'itération de décodage, avant de revenir à l'étape (31) pour l'itération suivante.

Le critère $\Gamma_n^{err}$ est lié à la convergence du processus de décodage itératif. Lorsque l'algorithme de décodage itératif converge, ses variations monotones fournissent une indication de rapidité de convergence, l'algorithme convergeant vers une unique séquence, ce qui se traduit par une diminution vers 0 de la valeur de $\Gamma_n^{err}$. L'effet "turbo" s'observe dans les cas de convergence après quelques itérations de la boucle de décodage, et la convergence rapide de l'algorithme de décodage se traduit par la diminution rapide de la valeur de $\Gamma_n^{err}$. Les situations de divergence peuvent ainsi être rapidement détectées par comparaison de $\Gamma_n^{err}$ au seuil $\theta_{div}$. En pratique, le choix de $\theta_{div}$ pourra résulter d'un compromis entre le risque de perte de performances et la quantité de ressources de calcul économisée.

Dans un second mode de réalisation de l'invention, un test de non convergence, basé sur l'observation des variations de $\Gamma_n^{err}$, est appliqué. Le seuil de non convergence est alors estimé à partir d'une mesure de l'écart entre deux estimations de la séquence de symboles obtenues lors d'itérations distinctes du processus de décodage dont l'une au moins diffère des itérations pour lesquelles la grandeur liée à la convergence du processus de décodage itératif est calculée. La procédure, illustrée sur la figure 4, est similaire à celle décrite précédemment pour les étapes (30) à (34), (36) et (37).

L'algorithme représenté sur la figure 4 est initialisé avec n = 1. Une boucle est exécutée pour les valeurs successives de l'index n. Chaque itération n dans cette boucle commence par l'obtention (31) de la séquence d'estimations $(\hat{u}_n^1, \hat{u}_n^2, ..., \hat{u}_n^N)$ à partir des quantités $L^2(u^k)$. L'étape (31) est comme décrit précédemment exécutée de manière coordonnée avec le processus de décodage itératif dont l'exécution fournit les quantités $L^2(u^k)$. Les séquences d'estimations ainsi obtenues sont ensuite mémorisées. Un test (38) est effectué pour distinguer le traitement opéré lors de la première itération, qui se limite à l'obtention de la séquence et sa mémorisation à l'étape précédente. Si l'itération en cours est au-delà de la première itération, on obtient (33) la distance de Hamming $D_n$ entre la séquence d'estimations $(\hat{u}_n^1, \hat{u}_n^2, ..., \hat{u}_n^N)$ obtenue à l'étape précédente (31) et la séquence d'estimations $(\hat{u}_{n-1}^1, \hat{u}_{n-1}^2, ..., \hat{u}_{n-1}^N)$ obtenue à l'étape (31) lors de l'itération précédente. En variante, on peut calculer la distance entre la séquence d'estimations $(\hat{u}_n^1, \hat{u}_n^2, ..., \hat{u}_n^N)$ courante et la séquence d'estimations $(\hat{u}_{n-p}^1, \hat{u}_{n-p}^2, ..., \hat{u}_{n-p}^N)$ obtenue à l'étape (31) lors d'une quelconque itération précédente n-p. La quantité $D_n$ obtenue à l'étape (33) peut ensuite être normalisée à l'étape (34) par la taille N de la séquence décodée pour obtenir le critère $\Gamma_n^{err}$. Un test (39) est ensuite effectué pour distinguer le traitement opéré lors des $N_{obs}'$ premières itérations au-delà de la première, au cours duquel le test d'arrêt (40) n'est pas effectué. Le nombre d'itérations de la boucle pour lesquelles ce traitement limité est opéré est déterminé par le paramètre $N_{obs}'$, choisi supérieur ou égal à 2. Un positionnement de $N_{obs}'$ au-delà de 2 permet de n'appliquer le critère d'arrêt du décodage qu'au bout d'un nombre déterminé d'itérations de décodage, offrant ainsi un degré supplémentaire de flexibilité du procédé selon l'invention. Lorsque la condition du test (39) est remplie, on calcule l'écart entre les critères $\Gamma_n^{err}$ et $\Gamma_{n-1}^{err}$. En variante, on peut calculer l'écart entre le critère obtenu pour l'itération en cours et le critère obtenu à l'étape (34) lors d'une quelconque itération précédente n-p. L'écart $\Gamma_n^{err} - \Gamma_{n-1}^{err}$ précédemment calculé est comparé à un seuil $\theta'_{div}$ à l'étape (40). Si l'écart est en deçà de ce seuil, une situation de non convergence est détectée, l'arrêt du processus de décodage itératif décidé (37) et la séquence déclarée non décodée (41). Ce qui revient à comparer la grandeur liée à la convergence $\Gamma_n^{err}$ à une mesure de l'écart $\Gamma_{n-1}^{err}$ corrigée de la valeur $\theta'_{div}$.

On peut aussi établir une moyenne des distances $\Gamma_n^{err} - \Gamma_{n-1}^{err}$ calculées à chaque itération n, et obtenir un critère de non convergence, sans sortir de l'esprit de l'invention.

La sortie des tests (38), (39) et (40) lorsque la condition de test n'est pas remplie conduit à l'incrémentation (36) de l'indice n d'itération de décodage, avant de revenir à l'étape (31 ) pour l'itération suivante.

Le seuil de non convergence selon l'invention peut être rendu adaptatif, par exemple en fonction du service (transmission de voix, de données selon une qualité de service déterminée ou non) dans les applications de radiocommunication, sans pour autant sortir du cadre de l'invention.

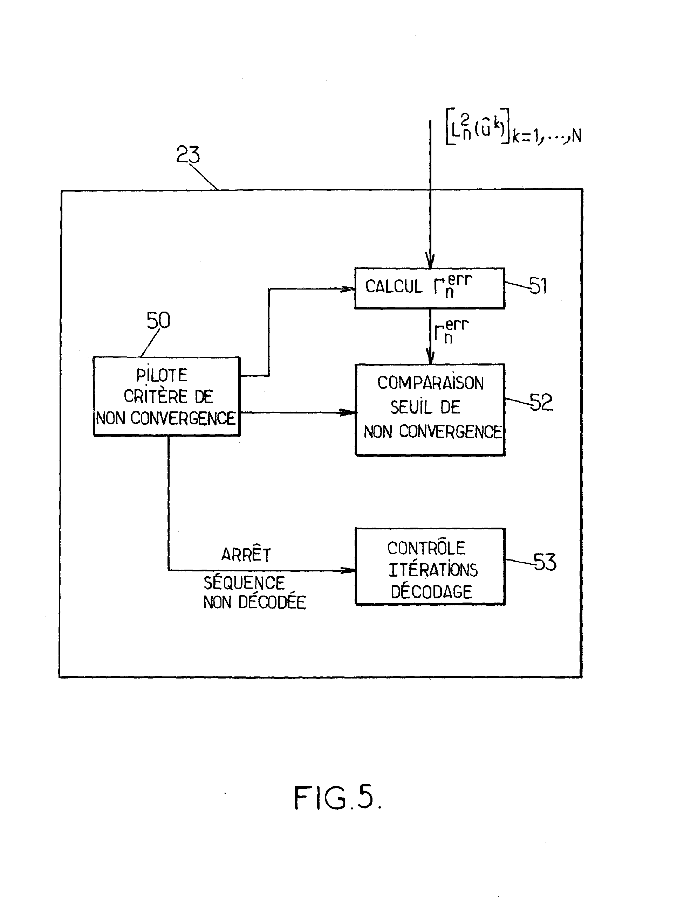

Le dispositif représenté sur la figure 5 comprend un module (50) de contrôle qui pilote la mise en oeuvre du procédé selon l'invention et actionne successivement un module (51) de calcul d'une grandeur liée à la convergence du processus de décodage itératif et un module (52) de comparaison de cette grandeur avec un seuil de non convergence. Selon les premier et second modes de réalisation précédemment décrits, le module (51) reçoit les quantités $L^2(u^k)$ en sortie du second décodeur constituant (21). Les modules (50-52) sont intégrés au module (23) de contrôle du processus itératif de décodage décrit précédemment. Lorsqu'une situation de non convergence est détectée, et l'arrêt du processus de décodage itératif décidé, le module (50) transmet une information d'arrêt du décodage en déclarant la séquence non décodée à un module (53) de contrôle des itérations du décodage, lui aussi intégré au module (23).

Conformément au premier mode de réalisation décrit ci-dessus, les moyens (52) seront agencés pour comparer la grandeur liée à la convergence à un seuil de non convergence obtenu à partir d'une valeur prédéterminée, et les moyens (50) seront agencés pour stopper le processus de décodage itératif dès lors que la grandeur liée à la convergence du processus de décodage itératif est supérieure à cette valeur.

Conformément au second mode de réalisation décrit ci-dessus, les moyens (52) seront agencés pour comparer la grandeur liée à la convergence à un seuil de non convergence estimé à partir d'une mesure de l'écart entre deux estimations de la séquence de symboles obtenues lors d'itérations distinctes du processus de décodage dont l'une au moins diffère des itérations pour lesquelles la grandeur liée à la convergence du processus de décodage itératif est calculée. De préférence, ils seront agencés pour comparer la grandeur liée à la convergence à un seuil de non convergence obtenu à partir de ladite mesure d'écart corrigée d'une valeur prédéterminée.

## Revendications

1. Procédé de contrôle du nombre d'itérations d'un processus de décodage itératif d'une séquence de symboles codée selon un schéma de codage par concaténation de codes convolutifs, dans lequel, pour une itération au-delà de la première :

   \a\ on calcule une grandeur liée à la convergence du processus de décodage itératif ;

   \b\ on compare cette grandeur à un seuil de non convergence ;

   \c\ on stoppe le processus de décodage itératif en fonction de cette comparaison en déclarant la séquence non décodée.

2. Procédé selon la revendication 1, dans lequel la grandeur liée à la convergence du processus de décodage itératif mesure l'écart entre deux estimations de la séquence de symboles obtenues lors d'itérations distinctes du processus de décodage.

3. Procédé selon la revendication 2, dans lequel ledit écart est mesuré selon une distance de Hamming.

4. Procédé selon l'une quelconque des revendication 1 à 3, dans lequel le seuil de non convergence est obtenu à partir d'une valeur prédéterminée, et le processus de décodage itératif stoppé dès lors que la grandeur liée à la convergence du processus de décodage itératif est supérieure à cette valeur.

5. Procédé selon la revendication 2 ou 3, dans lequel le seuil de non convergence est estimé à partir d'une mesure de l'écart entre deux estimations de la séquence de symboles obtenues lors d'itérations distinctes du processus de décodage dont l'une au moins diffère des itérations pour lesquelles la grandeur liée à la convergence du processus de décodage itératif est calculée.

6. Procédé selon la revendication 5, dans lequel le seuil de non convergence est obtenu à partir de ladite mesure d'écart corrigée d'une valeur prédéterminée.

7. Procédé selon l'une quelconque des revendications précédentes, dans lequel la séquence de symboles est codée selon un schéma de turbo-codage.

8. Dispositif de contrôle du nombre d'itérations d'un processus de décodage itératif d'une séquence de symboles codée selon un schéma de codage par concaténation de codes convolutifs, comprenant des moyens (51 ) pour calculer une grandeur liée à la convergence du processus de décodage itératif, des moyens (52) pour comparer cette grandeur à un seuil de non convergence, et des moyens (50,53) pour stopper le processus de décodage itératif en fonction de cette comparaison en déclarant la séquence non décodée.

9. Dispositif selon la revendication 8, dans lequel les moyens (51 ) de calcul de la grandeur liée à la convergence comprennent des moyens pour mesurer l'écart entre deux estimations de la séquence de symboles obtenues lors d'itérations distinctes du processus de décodage.

10. Dispositif selon la revendication 9, dans lequel les moyens pour mesurer l'écart entre deux estimations de la séquence de symboles obtenues lors d'itérations distinctes du processus de décodage sont agencés pour mesurer ledit écart selon une distance de Hamming.

11. Dispositif selon l'une quelconque des revendications 8 à 10, dans lequel les moyens (52) de comparaison sont agencés pour comparer la grandeur liée à la convergence à un seuil de non convergence obtenu à partir d'une valeur prédéterminée, et les moyens (50) sont agencés pour stopper le processus de décodage itératif dès lors que la grandeur liée à la convergence du processus de décodage itératif est supérieure à cette valeur.

12. Dispositif selon la revendication 9 ou 10, dans lequel les moyens (52) de comparaison sont agencés pour comparer la grandeur liée à la convergence à un seuil de non convergence estimé à partir d'une mesure de l'écart entre deux estimations de la séquence de symboles obtenues lors d'itérations distinctes du processus de décodage dont l'une au moins diffère des itérations pour lesquelles la grandeur liée à la convergence du processus de décodage itératif est calculée.

13. Dispositif selon la revendication 12, dans lequel les moyens (52) de comparaison sont agencés pour comparer la grandeur liée à la convergence à un seuil de non convergence obtenu à partir de ladite mesure d'écart corrigée d'une valeur prédéterminée.

14. Dispositif selon l'une quelconque des revendications 8 à 13, dans lequel les moyens (50-53) pour stopper le processus de décodage itératif sont agencés pour le contrôle du nombre d'itérations d'un processus de décodage itératif d'une séquence de symboles codée selon un schéma de turbo-codage.

15. Programme d'ordinateur, chargeable dans une mémoire associée à un processeur, et comprenant des portions de code pour la mise en oeuvre d'un procédé selon l'une quelconque des revendications 1 à 7 lors de l'exécution dudit programme par le processeur.

16. Support informatique, sur lequel est enregistré un programme selon la revendication 15.

FIG.1.

FIG.2.

FIG.3.

$$\boxed{\begin{array}{c} \text{INITIALISATION} \\ n = 1 \end{array}} \rightarrow 30$$

$$\left[ L_n^2 (\hat{u}^k) \right]_{k=1\ldots N} \longrightarrow \boxed{(\hat{u}_n^1, \hat{u}_n^2, \ldots, \hat{u}_n^N)} \rightarrow 31$$

$$\boxed{n \leftarrow n+1} \rightarrow 36$$

$$32 \quad \langle n > 1 ? \rangle \quad \text{OUI} \qquad \text{NON}$$

$$D_n = DH\left[(\hat{u}_n^1, \hat{u}_n^2, \ldots, u_n^N) ; (\hat{u}_{n-1}^1, \hat{u}_{n-1}^2, \ldots, \hat{u}_{n-1}^N)\right] \quad 33$$

$$\boxed{\Gamma_n^{err} = \frac{D_n}{N}} \rightarrow 34$$

$$\text{OUI} \quad \langle n > N_{obs}' ? \rangle \quad \text{NON} \qquad 39$$

$$\text{OUI} \quad \langle \Gamma_n^{err} - \Gamma_{n-1}^{err} < \theta_{div}' ? \rangle \quad \text{NON} \qquad 40$$

$$\boxed{\begin{array}{c} \text{ARRÊT} \\ \text{DÉCODAGE} \\ \text{ITÉRATIF} \end{array}} \rightarrow 37$$

$$\boxed{\begin{array}{c} \text{SEQUENCE} \\ \text{NON DÉCODÉE} \end{array}} \rightarrow 41$$

FIG.4 .

$$\left[L_n^2(\hat{u}^k)\right]_{k=1,\cdots,N}$$

23

| CALCUL $\Gamma_n^{err}$ | —51 |

$\Gamma_n^{err}$

50

| PILOTE CRITÈRE DE NON CONVERGENCE |

| COMPARAISON SEUIL DE NON CONVERGENCE | —52 |

ARRÊT

SÉQUENCE NON DÉCODÉE

| CONTRÔLE ITÉRATIONS DÉCODAGE | —53 |

# FIG.5.

Office européen
des brevets

# RAPPORT DE RECHERCHE EUROPEENNE

Numéro de la demande

EP 04 29 0220

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | US 6 499 128 B1 (RALEIGH GREGORY G ET AL) 24 décembre 2002 (2002-12-24) * alinéa [0070] - alinéa [0080]; figures 5-8 * | 1-16 | H03M13/29 |
| A | WO 01/76079 A (ADVANCED HARDWARE ARCHITECTURE) 11 octobre 2001 (2001-10-11) * page 23, colonne 33 - page 26, colonne 29 * | 1-16 | |
| A | EP 1 160 989 A (FUJITSU LTD) 5 décembre 2001 (2001-12-05) * alinéa [0035] - alinéa [0036]; figure 2 * | 1-16 | |
| A | EP 1 217 776 A (SAMSUNG ELECTRONICS CO LTD) 26 juin 2002 (2002-06-26) | | |
| D,A | HAGENAUER J ET AL: "ITERATIVE DECODING OF BINARY BLOCK AND CONVOLUTIONAL CODES" IEEE TRANSACTIONS ON INFORMATION THEORY, IEEE INC. NEW YORK, US, vol. 42, no. 2, mars 1996 (1996-03), pages 429-445, XP000850507 ISSN: 0018-9448 | | DOMAINES TECHNIQUES RECHERCHES (Int.Cl.7) H03M |
| A | GARRETT D ET AL: "Energy efficient Turbo Decoding for 3G Mobile" PROCEEDINGS OF THE 2001 INTERNATIONAL SYMPOSIUM ON LOW POWER ELECTRONICS AND DESIGN.ISLPED. HUNTINGTON BEACH, CA, AUG. 6 - 7, 2001, INTERNATIONAL SYMPOSIUM ON LOW POWER ELCTRONICS AND DESIGN, NEW YORK, NY : ACM, US, 6 août 2001 (2001-08-06), pages 328-333, XP002215915 ISBN: 1-58113-371-5 | | |

-/--

Le présent rapport a été établi pour toutes les revendications

| Lieu de la recherche | Date d'achèvement de la recherche | Examinateur |
|---|---|---|
| La Haye | 19 mai 2004 | Devergranne, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.....................................................................
& : membre de la même famille, document correspondant

EPO FORM 1503 03.82 (P04C02)

Office européen
des brevets

**RAPPORT DE RECHERCHE EUROPEENNE**

Numéro de la demande

EP 04 29 0220

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| D,A | US 5 761 248 A (HAGENAUER JOACHIM ET AL) 2 juin 1998 (1998-06-02) ----- | | |
| A | US 2001/028690 A1 (EBEL WILLIAM J) 11 octobre 2001 (2001-10-11) ----- | | |

DOMAINES TECHNIQUES RECHERCHES (Int.Cl.7)

Le présent rapport a été établi pour toutes les revendications

| Lieu de la recherche | Date d'achèvement de la recherche | Examinateur |
|---|---|---|
| La Haye | 19 mai 2004 | Devergranne, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 04 29 0220

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

19-05-2004

| Document brevet cité au rapport de recherche | | Date de publication | Membre(s) de la famille de brevet(s) | | Date de publication |
|---|---|---|---|---|---|
| US 6499128 | B1 | 24-12-2002 | US | 6725411 B1 | 20-04-2004 |
| WO 0176079 | A | 11-10-2001 | AU | 8929601 A | 15-10-2001 |
| | | | CA | 2404984 A1 | 11-10-2001 |
| | | | EP | 1281241 A2 | 05-02-2003 |
| | | | JP | 2003534680 T | 18-11-2003 |
| | | | WO | 0176079 A2 | 11-10-2001 |
| | | | US | 2004010747 A1 | 15-01-2004 |
| | | | US | 2002026615 A1 | 28-02-2002 |
| EP 1160989 | A | 05-12-2001 | WO | 0052832 A1 | 08-09-2000 |
| | | | EP | 1160989 A1 | 05-12-2001 |
| | | | US | 2001052099 A1 | 13-12-2001 |
| EP 1217776 | A | 26-06-2002 | KR | 2002052112 A | 02-07-2002 |
| | | | CA | 2400469 A1 | 04-07-2002 |
| | | | CN | 1406415 T | 26-03-2003 |
| | | | EP | 1217776 A2 | 26-06-2002 |
| | | | GB | 2374500 A ,B | 16-10-2002 |
| | | | WO | 02052734 A1 | 04-07-2002 |
| | | | US | 2003066018 A1 | 03-04-2003 |
| US 5761248 | A | 02-06-1998 | DE | 19526416 A1 | 23-01-1997 |
| | | | DE | 59610289 D1 | 08-05-2003 |
| | | | EP | 0755122 A2 | 22-01-1997 |
| | | | ES | 2196106 T3 | 16-12-2003 |
| US 2001028690 | A1 | 11-10-2001 | AUCUN | | |

EPO FORM P0460